# EUROPÄISCHE PATENTANMELDUNG

(11) **EP 1 233 230 A2**
(43) Veröffentlichungstag der Anmeldung: **21.08.2002**
(21) Anmeldenummer: 02002342.0
(22) Anmeldetag: 31.01.2002
(51) Int. Cl.: F16P 3/08

(54) **Sicherheitszuhaltung für eine Tür, Klappe od. dgl.**

(30) Priorität: 17.02.2001 DE 20102819 U
(71) Anmelder: K.A. SCHMERSAL GmbH & Co., D-42279 Wuppertal (DE)
(72) Erfinder: Türk, Stefan, Dr., 79211 Denzlingen (DE)
(74) Vertreter: Sparing Röhl Henseler Patentanwälte

(57) **Zusammenfassung**

Die Erfindung betrifft eine Sicherheitszuhaltung für eine Tür, Klappe od.dgl., mit einem Gehäuse (1) umfassend wenigstens einen Sicherheitsschalter (2) mit einem Betätiger (3), einem Zuhalteelement (7), dessen Zuhaltefunktion über einen von einer Steuerung über ein Ansteuersignal ansteuerbaren Antrieb (6) aktivierbar ist, wenigstens einen die Position des Betätigers (3) detektierenden Signalgebers (5) und wenigstens einen die Position des Antriebs (6) und/oder des Zuhalteelements (7) detektierenden Signalgebers (8) zur Erzeugung entsprechender zweikanaliger Signale, wobei in dem Gehäuse (1) ein elektrischer Schnittstellenkreis (9) zum Anschließen an einen Datenbus (10) vorgesehen ist, wobei der Schnittstellenkreis (9) die Signale der Signalgeber (5, 8) und das Ansteuersignal auf das Datenprotokoll des Datenbusses (10) umsetzt bzw. aus diesem gewinnt.

## Beschreibung

Die Erfindung betrifft eine Sicherheitszuhaltung für eine Tür, Klappe od.dgl. nach dem Oberbegriff des Anspruchs 1.

Zum Schutz von Menschen vor gefährlichen Bewegungen von Maschinen werden an Türen, Klappen od.dgl. Sicherheitszuhaltungen, die Sicherheitsschalter umfassen, eingesetzt. Diese haben die Aufgabe zu verhindern, daß die Tür, Klappe od.dgl. geöffnet werden kann, solange von der Bewegung hinter der Tür, Klappe od.dgl. eine Verletzungsgefahr ausgehen könnte. Derartige Sicherheitszuhaltungen werden konventionell verdrahtet in eine Sicherheitssteuerung einer Maschine unter Verwendung von Klemmen und/oder Steckern eingebunden. Hierdurch werden allgemein für jedes Signal, das die Sicherheitszuhaltung mit seiner Umgebung austauscht, zwei elektrische Adern an der Sicherheitszuhaltung angeschlossen und mit der Steuerung bzw. Sicherheitssteuerung der Maschine verbunden. Diese Art der Verdrahtung ist aufwendig und teuer.

Aufgabe der Erfindung ist es daher, eine Sicherheitszuhaltung nach dem Oberbegriff des Anspruchs 1 zu schaffen, die eine weniger aufwendige und damit billigere Verdrahtung ermöglicht.

Diese Aufgabe wird entsprechend dem kennzeichnenden Teil des Anspruchs 1 gelöst.

Weitere Ausgestaltungen der Erfindung sind den Unteransprüchen und der nachfolgenden Beschreibung zu entnehmen.

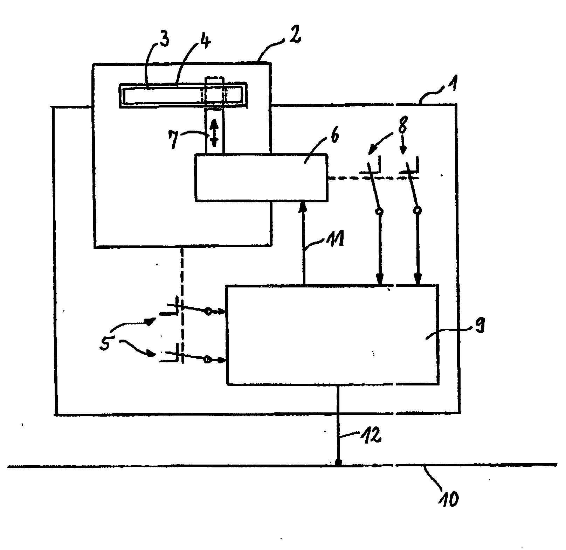

In der beigefügten Abbildung ist schematisch eine Ausführungsform einer Sicherheitszuhaltung dargestellt.

Letztere umfaßt ein Gehäuse 1, das an einem feststehenden Bauteil, das mit einer Tür, Klappe od.dgl. versehen ist, der Öffnungs- bzw. Schließstellung über eine Steuerung zu überwachen und aufrechtzuerhalten ist, befestigt ist und einen Sicherheitsschalter 2 umfaßt, der mittels eines Betätigers 3 betätigbar ist, der selbst an der Tür, Klappe od.dgl. angebracht ist und in einen Schlitz 4 des Sicherheitsschalters 2 zu dessen Betätigung einführbar ist.

Der Sicherheitsschalter 2 umfaßt wenigstens einen Signalgeber 5, hier in Form von Schließer- und/oder Öffnerkontakten, die durch Einführen des Betätigers 3 in den Schlitz 4 infolge Schließens der Tür, Klappe od.dgl. entsprechend ihrer Funktion geschlossen bzw. geöffnet werden bzw. durch Herausziehen des Betätigers 3 aus dem Schlitz 4 infolge Öffnens der Tür, Klappe od.dgl. entsprechend ihrer Funktion geöffnet bzw. geschlossen werden. - Bei dem oder den Signalgebern 5 kann es sich aber auch um andere mechanische oder berührungslose (auf optischer, magnetischer, induktiver oder kapazitiver Basis) Kontakte oder Sensoren handeln, die die Position des Betätigers detektieren.

Ferner ist in dem Gehäuse 1 ein Antrieb 6 für ein Zuhalteelement 7 vorgesehen, das mit dem Betätiger 3 in Eingriff bringbar ist, um zu bewirken, daß der Betätiger 3 nicht aus dem Sicherheitsschalter 2 entfernbar ist. Bei dem Antrieb 6 kann es sich um einen Motor, einen Elektromagneten od.dgl. handeln, während das Zuhalteelement 7 beispielsweise ein verschiebbarer oder verdrehbarer Riegel od.dgl. sein kann.

Ferner ist in dem Gehäuse 1 wenigstens ein Signalgeber 8, der in Form von einem oder mehreren mechanischen oder berührungslosen (auf optischer, magnetischer, induktiver oder kapazitiver Basis) Kontakten bzw. Sensoren ausgebildet sein kann, vorgesehen, um die Position des Antriebs 5 und/oder des Zuhalteelements 7 zu detektieren.

Die Signalgeber 5, 8 liefern zweikanalige und damit redundante Signale.

Schließlich ist in dem Gehäuse 1 ein elektrischer Schnittstellenkreis 9 zum Anschließen der Sicherheitszuhaltung an einen Datenbus 10 angeordnet, wobei der Schnittstellenkreis 9 mit den einzelnen Signalgebern 5, 8 elektrisch verbunden ist. Als mögliche Datenbusse 10 kommen insbesondere Standardbusse wie AS-i, Profibus, Device-Net, Ethernet-TCP/IP, Interbus-S oder ähnliche serielle Bussysteme in Frage, und zwar jeweils mit ihren sicherheitstechnischen Zusatzprotokollen bzw. -mechanismen, im Falle von AS-i wäre dies AS-i Safety at Work, im Falle von Profibus ProfiSafe.

Die Signale der Signalgeber 5, 8 werden durch den Schnittstellenkreis 9 auf das Datenprotokoll des Datenbusses 10 umgesetzt.

Ferner ist der Antrieb 5 über eine Ansteuerleitung 11 mit dem Schnittstellenkreis 9 verbunden, wobei letzterer aus einem über den Datenbus 10 von der Steuerung oder Sicherheitssteuerung einer zugehörigen Maschine gelieferten Signal ein Ansteuersignal für den Antrieb 6 gewinnt, das dem Antrieb über die Ansteuerleitung 11 zugeführt wird.

Der Datenbus 10 kann ein oder zwei Kabel umfassen, wobei in letzterem Fall jeweils Daten und Energie getrennt übertragen werden, während im ersten Fall Daten und Energie gemeinsam übertragen werden. Der Schnittstellenkreis 9 wird über eine entsprechende Schnittstelle 12 mit dem jeweiligen Buskabel verbunden, wordurch das Anschließen der Sicherheitszuhaltung erheblich vereinfacht und verbilligt wird.

Der Schnittstellenkreis 9 kann als Chip ausgebildet oder aus mehreren elektronischen Bauteilen aufgebaut sein.

## Patentansprüche

1. Sicherheitszuhaltung für eine Tür, Klappe od.dgl., mit einem Gehäuse (1) umfassend wenigstens einen Sicherheitsschalter (2) mit einem Betätiger (3), einem Zuhalteelement (7), dessen Zuhaltefunktion über einen von einer Steuerung über ein Ansteuersignal ansteuerbaren Antrieb (6) aktivierbar ist, wenigstens einen die Position des Betätigers (3) detektierenden Signalgebers (5) und wenigstens einen die Position des Antriebs (6) und/oder des Zuhalteelements (7) detektierenden Signalgebers (8) zur Erzeugung entsprechender zweikanaliger Signale, **dadurch gekennzeichnet, daß** in dem Gehäuse (1) ein elektrischer Schnittstellenkreis (9) zum Anschließen an einen Datenbus (10) vorgesehen ist, wobei der Schnittstellenkreis (9) die Signale der Signalgeber (5, 8) und das Ansteuersignal auf das Datenprotokoll des Datenbusses (10) umsetzt bzw. aus diesem gewinnt.

2. Sicherheitszuhaltung nach Anspruch 1, **dadurch gekennzeichnet, daß** der elektrische Schnittstellenkreis (9) als Chip ausgebildet ist.

3. Sicherheitszuhaltung nach Anspruch 1, **dadurch gekennzeichnet, daß** der elektrische Schnittstellenkreis (9) aus elektronischen Bauteilen aufgebaut ist.

4. Sicherheitszuhaltung nach einem der Ansprüche 1 bis 3, **dadurch gekennzeichnet, daß** die Signalgeber (5, 8) jeweils einen oder mehrere mechanische oder berührungslose Kontakte bzw. Sensoren umfassen.

5. Sicherheitszuhaltung nach einem der Ansprüche 1 bis 4, **dadurch gekennzeichnet, daß** der elektrische Schnittstellenkreis (9) zur Energieübertragung vom Datenbus (10) auf die Sicherheitszuhaltung zu deren Energieversorgung ausgebildet ist.
